# EUROPÄISCHE PATENTSCHRIFT

(11) **EP 0 337 222 B1**
(45) Veröffentlichungstag und Bekanntmachung des Hinweises auf die Patenterteilung: **02.11.1994**
(21) Anmeldenummer: 89105768.9
(22) Anmeldetag: 01.04.1989
(51) Int. Cl.: H03G 3/18, H03G 1/00

(54) **Steuerbare Verstärkerschaltung**
Controllable amplifier circuit
Circuit amplificateur réglable

(30) Priorität: 11.04.1988 DE 3811947
(43) Veröffentlichungstag der Anmeldung: 18.10.1989
(73) Patentinhaber: TEMIC TELEFUNKEN microelectronic GmbH, 74072 Heilbronn (DE)
(72) Erfinder: Rinderle, Heinz, D-7100 Heilbronn (DE)
(74) Vertreter: Maute, Hans-Jürgen, Dipl.-Ing.

(56) Entgegenhaltungen:
- EP-A- 0 166 973
- DE-B- 1 286 152
- US-A- 3 368 156
- US-A- 3 531 732
- US-A- 3 651 420
- US-A- 4 498 056
- US-A- 4 724 398
- IEEE TRANSACTIONS ON CONSUMER ELECTRONICS, Band CE-28, Nr. 3, August 1982,Seiten 168-183, New York, US; M. LONG et al.: "An integrated video IF amplifier and PLL detection system"

## Beschreibung

Die Erfindung betrifft eine steuerbare Verstärkerschaltung nach dem Oberbegriff des Anspruchs 1. Eine derartige Verstärkerschaltung ist aus US-A-3 368 156 bekannt und beschreibt einen Verstärker mit gesteuerter Verstärkung, wobei ein erster und ein zweiter Transistor in Basisgrundschaltung geschaltet sind. Das Steuersignal (AGC) wird dem zweiten Transistor an seiner Basis zugeführt und stellt dadurch seine Verstärkung ein; die Verstärkung des ersten Transistors ist fest eingestellt und wird nicht verändert.

US-A-3 651 420 beschreibt eine Verstärkerschaltung mit variabler Verstärkung, aufgebaut auf einem Verstärkertransistor in Emittergrundschaltung und einem weiteren Transistor, der gleichzeitig das Eingangssignal abschwächt und die Verstärkung des Verstärkertransistors ändert.

Die in DE-A-1 286 152 beschriebene Schaltung enthält einen Verstärkungstransistor in Emittergrundschaltung mit fest eingestellter Verstärkung und einen Hilfstransistor, dessen Verstärkung mittels der seiner Basis zugeführten Regelspannung eingestellt wird.

In US-A-4 498 056 wird ein zweistufiger steuerbarer Verstärker beschrieben, bei dem das Steuersignal sowohl an der Basis des Verstärkungstransistors der ersten Stufe als auch an der Basis des Verstärkungstransistors der zweiten Stufe anliegt. Das im Standby-Betrieb unerwünschte Empfangssignal wird ab einem fest eingestellten Schwellwert über eine Nebenschlußschaltung abgeleitet.

Allen genannten Verstärkungsschaltungen ist gemeinsam, daß zur Verstärkungsregelung das Basispotential des einen der beiden Transistoren und damit seine Verstärkung konstant gehalten wird, während dem anderen Transistor an seiner Basis eine Regelspannung zugeführt wird. Demzufolge wird die Verstärkung durch die Regelspannung eingestellt, die die Aufteilung des Eingangsstroms auf die beiden Zweige des Verstärkers bestimmt. Nachteilig hierbei ist, daß sich mit jeder Änderung der Regelspannung auch die Belastung der Spannungsquelle des Verstärkers und die Belastung der Signalquelle ändert, was sowohl für die Spannungsquelle als auch für die Signalquelle einen erheblich größeren Designaufwand erfordert. Aufgabe der Erfindung ist es, eine steuerbare Verstärkerschaltung anzugeben, bei der die Belastung der Spannungsquelle unabhängig vom jeweiligen Regelzustand der Verstärkungssteuerung ist und bei der zwecks konstanter Belastung der Signalquelle die Eingangsadmittanz konstant bleibt.

Diese Aufgabe wird durch eine steuerbare Verstärkerschaltung mit den kennzeichnenden Merkmalen des Anspruchs 1 gelöst. Vorteilhafte Ausgestaltungen der Erfindung sind in den Unteransprüchen gekennzeichnet. Die Erfindung wird nachstehend anhand von Ausführungsbeispielen erläutert.

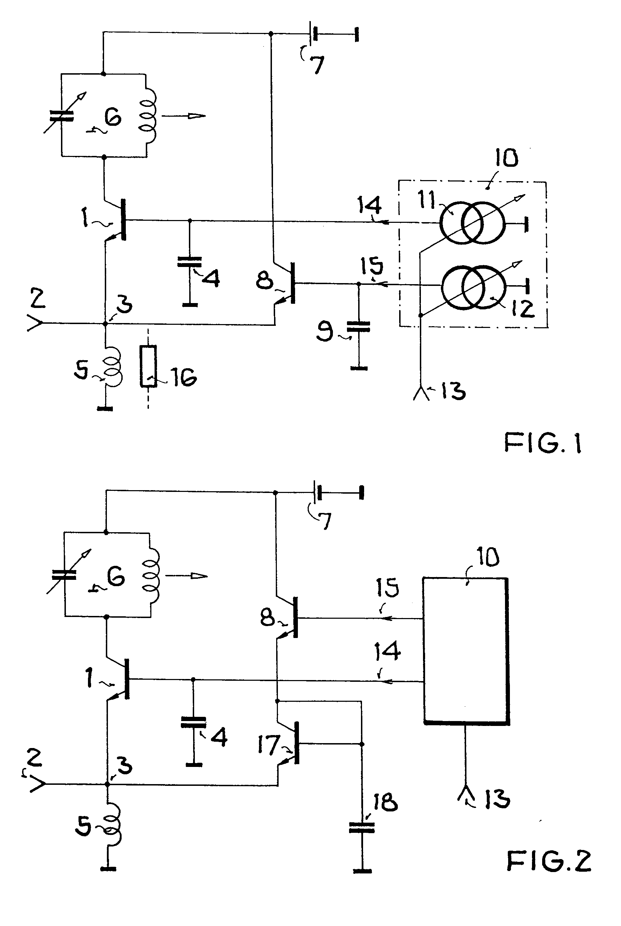

Die Figur 1 zeigt eine steuerbare Verstärkerschaltung nach der Erfindung. Bei der Verstärkerstufe der Figur 1 handelt es sich beispielsweise um einen selektiven Hochfrequenzverstärker, dessen Verstärkung steuerbar ist. Der Verstärkertransistor 1 arbeitet bei der Schaltung der Figur 1 für das zu verstärkende Signal in Basis-Grundschaltung, bei der das Eingangssignal 2 dem Emitter des Verstärkertransistors 1 über den Eingang 3 zugeführt wird. Die Basis des Transistors 1 ist über den Kondensator 4 mit dem Bezugspunkt (Masse) verbunden. Zwischen dem Eingang 3 und dem Bezugspunkt liegt eine Spule 5, die das Eingangssignal wechselstrommäßig vom Bezugspunkt trennt. Das Kollektorausgangssignal des Transistors 1 wird einem Selektionskreis 6 zugeführt, der ein bestimmtes Signal ausselektiert. Das ausselektierte Signal wird aus dem Selektionskreis ausgekoppelt (Pfeil) und beispielsweise einer (nicht dargestellten) Mischstufe zugeführt. Als Betriebsspannungsquelle dient die Spannungsquelle 7.

Der Eingang 3 der Schaltung ist nicht nur mit dem Emitter des Transistors 1, sondern auch mit dem Emitter eines weiteren Transistors 8 verbunden. Die Basis des Transistors 8 ist für das Signal über einen Kondensator 9 mit dem Bezugspunkt verbunden. Die Basen der Transistoren 1 und 8 werden gleichstrommäßig von steuerbaren Stromquellen einer Steuerschaltung 10 angesteuert. Im Ausführungsbeispiel der Figur 1 besteht die Steuerschaltung 10 aus zwei steuerbaren Stromquellen 11 und 12. Die Stromquellen 11 und 12 werden von einem Steuersignal 13 angesteuert. Mit Hilfe des Steuersignals 13 werden die Basisströme 14 und 15 der Transistoren 1 und 8 gesteuert. Die Steuerung der Basisströme bewirkt eine Steuerung der Verstärkung der Schaltung.

Im ungeregelten Zustand (Verstärkungsmaximum) wird nur der Basis des Transistors 1 ein Basisstrom (14) zugeführt, während der Basis des Transistors 8 kein Basisstrom zugeführt wird. In diesem Fall wird das Eingangssignal ausschließlich über die Emitter-Kollektorstrecke des Transistors 1 dem Selektionskreis 6 zugeführt. Zur Verstärkungsreduzierung erhält auch die Basis des Transistors 8 Basisstrom. Erhält der Transistor 8 Basisstrom, so wird er leitend gesteuert. Dies hat zur Folge, daß ein Teil des Signalstromes über die Emitter-Kollektorstrecke des Transistors 8 zur Spannungsquelle 7 abgeleitet wird. Dies wiederum hat zur Folge, daß der Signalstrom aufgeteilt wird, und zwar in einen Anteil, der zum Selektionskreis 6 geführt wird, und in einen Anteil, der zur Spannungsquelle 5 geführt wird. Dadurch vermindert sich der Signalstrom, der zum Selektionskreis 6 gelangt. Eine Reduzierung des zum Selektionskreis 6 gelangenden Signalstromes ist gleichbedeutend mit einer Reduzierung der Verstärkung der Verstärkerstufe.

Es empfiehlt sich, die Basisströme 14 und 15 für die Transistoren 1 und 8 gegensinnig zu steuern und dabei die Summe (Größe) der Basisströme 14 und 15 konstant zu halten. Bei dieser Art von Basisstromsteuerung bleibt die Belastung der Spannungsquelle 7 unabhängig vom jeweiligen Regelzustand. Die Spule 5 kann vorteilhaft so ausgebildet sein, daß sie als Teil des Eingangsselektionsnetzwerkes wirkt.

Bei der Schaltung der Figur 1 kann anstelle der Spule 5 ein Widerstand 16 zur wechselstrommäßigen Signaltrennung vom Bezugspotential vorgesehen sein. In diesem Falle ist die Steuerung der Basisströme 14 und 15 mit konstanter Summe vorteilhaft, da dadurch das Potential der Eingangsklemme 3 bei der Verstärkungssteuerung konstant bleibt. Ein weiterer Vorteil der konstanten Summe der Basisströme 14 und 15 ist, daß die Eingangsadmittanz der Verstärkerschaltung bei Steuerung konstant bleibt.

Die Anordnung der Figur 2 unterscheidet sich von der Anordnung der Figur 1 dadurch, daß ein dritter Transistor 17 vorgesehen ist, der als Diode geschaltet ist. Der Transistor 17 liegt mit seiner Emitter-Kollektorstrecke zwischen dem Eingang 3 und dem Emitter des weiteren Transistors 8. Die Basis und der Kollektor des dritten Transistors 17 sind über den Kondensator 18 mit dem Bezugspotential verbunden.

Die Schaltung der Figur 2 unterscheidet sich von der Schaltung der Figur 1 dadurch, daß bei der Schaltung der Figur 2 das Eingangssignal nicht zur Spannungsquelle 7 abgeleitet wird, sondern über den Kondensator 18 zum Bezugspotential. Dadurch, daß der Signalstrom von der Betriebsspannungsquelle 7 ferngehalten wird, werden Störungen auf der Zuleitung zur Spannungsquelle 7 vermieden. Störungen auf diesem Wege können entstehen, wenn starke Signale auftreten und diese auf andere mitintegrierte Schaltungsteile (z.B. Oszillator) einwirken.

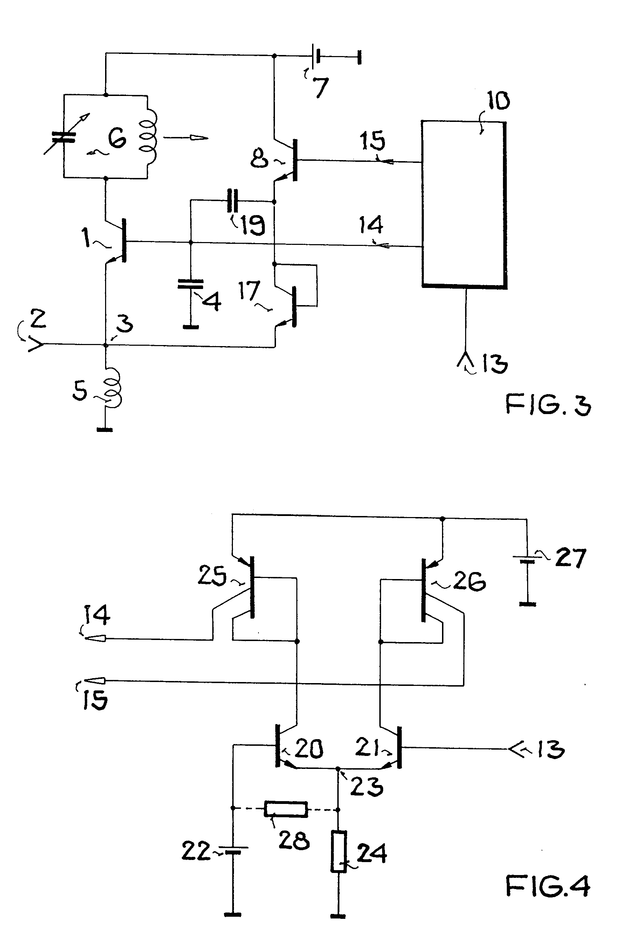

Die Schaltung der Figur 3 unterscheidet sich von der Schaltung der Figur 2 dadurch, daß bei der Schaltung der Figur 3 der Kondensator 18 der Figur 2 entfällt und stattdessen ein Kondensator 19 zwischen den gemeinsamen Basis-Kollektoranschluß des dritten Transistors 17 und die Basis des Transistors 1 geschaltet ist.

Bei einer Integration der Schaltung hat die Anordnung der Figur 3 mit einem Kondensator 19 zwischen der Basis des Transistors 1 und dem gemeinsamen Basis-Kollektoranschluß des dritten Transistors 17 den Vorteil, daß an dem Kondensator 19 eine kleinere Potentialdifferenz anliegt. Bei Ausführung des Kondensators 19 als Sperrschichtkondensator besteht die Möglichkeit, die Chipflächen für den Kondensator 19 kleiner zu machen, indem beispielsweise die Sperrschichtzonen des Kondensators 19 aus hochdotierten Schichten hergestellt werden.

Die Figur 4 zeigt ein Ausführungsbeispiel für die Steuerschaltung 10. Die Steuerschaltung 10 der Figur 4 weist eine Differenzschaltung mit den Transistoren 20 und 21 auf. Zwischen der Basis des Transistors 20 und dem Bezugspunkt liegt eine Spannungsquelle 22. Die Spannung der Spannungsquelle 22 wird vorzugsweise so gewählt, daß der Kollektorstrom des angesteuerten Verstärkertransistors 1 weitgehend temperaturabhängig bleibt. Die Emitter der beiden Transistoren 20 und 21 sind miteinander verbunden und zwischen dem Verbindungspunkt 23 der beiden Emitter und dem Bezugspunkt liegt ein Widerstand, der erfindungsgemäß als Pinchwiderstand ausgebildet ist. Wird der Widerstand 28, der ebenfalls ein Pinchwiderstand ist, eingesetzt, so lassen sich auch andere Spannungswerte für die Quelle 22 bei gleicher Temperaturunabhängigkeit realisieren.

Das Steuersignal 13 steuert bei der Schaltung der Figur 4 die Basis des Differenztransistors 21 an. Mit Hilfe des Steuersignals 13 wird die Verteilung der Emitterströme der beiden Differenztransistoren 20 und 21 gesteuert und damit werden durch das Steuersignal auch die Kollektorströme der Transistoren 20 und 21 gesteuert. Die Kollektorströme der Transistoren 20 und 21 steuern die Stromspiegeltransistoren 25 bzw. 26 an, deren gespiegelte Ausgangsströme 14 und 15 die Basisströme für die zu steuernden Transistoren 1 und 8 der Figuren 1, 2 und 3 liefern. Zwischen den Emittern der Stromspiegeltransistoren 25 und 26 und dem Bezugspunkt liegt eine Spannungsquelle 27.

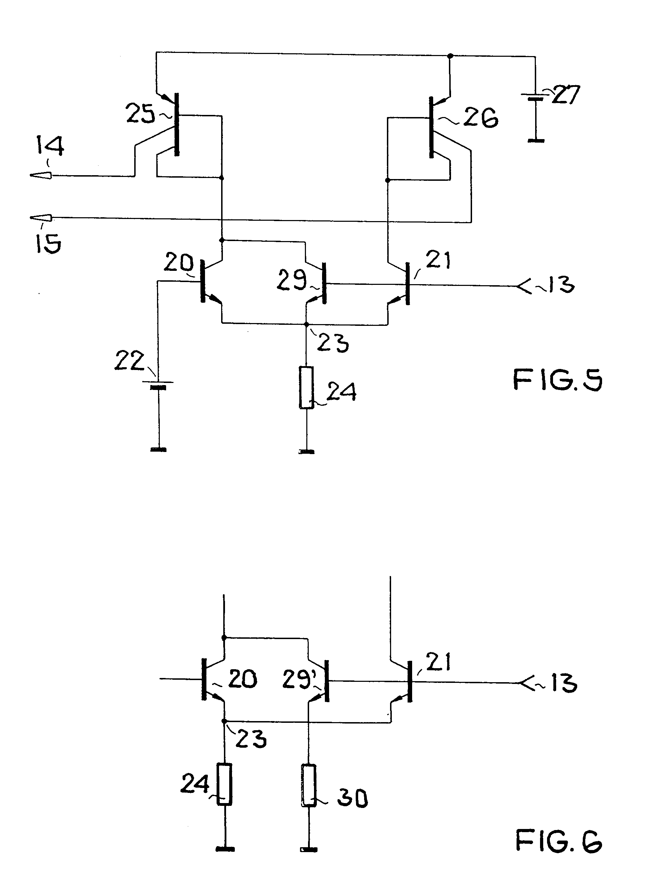

Die Schaltung der Figur 5 unterscheidet sich von der Schaltung der Figur 4 dadurch, daß in der Differenzschaltung noch ein zusätzlicher Transistor 29 vorgesehen ist, dessen Emitter mit dem Verbindungspunkt 23 verbunden ist und dessen Kollektor mit dem Kollektor des Transistors 20 verbunden ist. Der zusätzliche Transistor 29 verhindert, daß die Stromverteilung zwischen den Ausgangsströmen der Transistoren 20 und 21 beliebig wird. Dadurch wird erreicht, daß die Verstärkungsreduzierung der Schaltungen der Figuren 1 bis 3, die durch die Regelung herbeigeführt wird, begrenzt bleibt. Der Grad der Verstärkungsreduzierung hängt vom Verhältnis der Emitterflächen der Transistoren 21 und 29 ab.

Die Figur 6 zeigt eine Differenzschaltung, bei der nicht wie bei der Figur 5 der Emitter des Transistors 29 mit dem Verbindungspunkt 23 der Emitter der Transistoren 20 und 21 verbunden ist, sondern bei der Differenzschaltung der Figur 6 ist der Emitter des Transistors 29′ über einen Widerstand 30 mit dem Bezugspunkt verbunden. Bei der Schaltung der Figur 6 wird der Kollektorstrom des Transistors 29′ mit Hilfe des Widerstandes 30 eingestellt. Der Widerstand 30 ist ein Pinchwiderstand, der zusammen und im gleichen Arbeitsgang mit der Basiszone der Transistoren hergestellt wird.

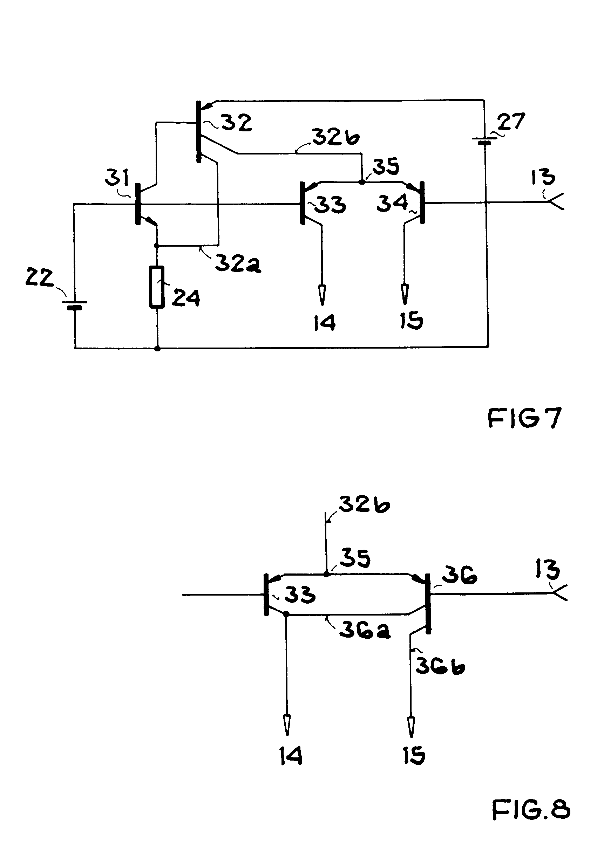

Die Figur 7 zeigt eine weitere Ausführungsform der Steuerschaltung 10. Die Steuerschaltung der Figur 7 weist eine Stromspiegelschaltung auf, die aus dem Transistor 31 und dem Mehrkollektortransistor 32 besteht. Der Kollektor des Transistors 31 ist mit der Basis des Transistors 32 verbunden. Der Emitter des Transistors 32 ist mit der Spannungsquelle 27 verbunden. Der Emitter des Transistors 31 ist mit dem Kollektor 32a des Transistors 32 sowie über einen Pinchwiderstand 24′ mit dem Bezugspunkt verbunden. Die Basis des Transistors 31 ist mit der Spannungsquelle 22 verbunden.

Bei der Steuerschaltung der Figur 7 ist weiterhin eine Differenzschaltung vorgesehen, die aus den Transistoren 33 und 34 besteht. Die Kollektorströme 14 bzw. 15 der Transistoren 33 und 34 werden der Verstärkerschaltung (Transistor 1 und 8) zugeführt. Das Steuersignal 13 wird der Basis des Transistors 34 zugeführt. Die Basis des Transistors 33 ist mit der Spannungsquelle 22 verbunden. Der Kollektor 32b des Transistors 32 ist mit dem Verbindungspunkt 35 der Emitter der beiden Transistoren 33 und 34 verbunden.

Die Stromspiegelschaltung (31, 32) liefert einen Strom, der den Emittern der Transistoren 33 und 34 über den Verbindungspunkt 35 zugeführt wird. Das Steuersignal 13 bestimmt die Stromverteilung der Ströme, die zu den Ausgängen 14 und 15 der Steuerschaltung gelangen.

Die Steuerschaltung der Figur 7 hat den Vorteil, daß die Ausgangsströme 14 und 15 von Änderungen der Betriebsspannungsquelle 27 relativ unabhängig sind.

Die Figur 8 zeigt eine Differenzschaltung, die anstelle der Differenzschaltung der Figur 7 eingesetzt werden kann. Die Differenzschaltung der Figur 8 besteht aus einem Transistor 33 und einem Mehrkollektortransistor 36, dessen einer Kollektor 36b mit dem Ausgang 15 verbunden ist. Die Verwendung eines Mehrkollektortransistors (36) anstelle eines normalen Transistors (34) hat den Vorteil, daß das Stromverhältnis der beiden Ströme 14 und 15 begrenzt werden kann.

Wie bereits zum Ausdruck gebracht, werden sämtliche Pinchwiderstände der gezeigten Schaltungen gleichzeitig und im gleichen Arbeitsgang wie die Basiszonen der in einem gemeinsamen Halbleiterkörper mitintegrierten (npn) Transistoren hergestellt.

Die Figur 9 zeigt eine Integrationsmöglichkeit für die Abblockkondensatoren (4, 9) der Transistoren 1 und 8 sowie der Kapazität 19, die der Kapazität 19 in der Figur 3 entspricht. Bei einer Integration werden gemäß der Figur 9 die Abblockkapazitäten 4 bzw. 9 durch Sperrschichtkapazitäten 4′ bzw. 9′ realisiert. Bei der Anordnung der Figur 9 befindet sich zwischen den beiden Sperrschichtkapazitäten 4′ und 9′ die Sperrschichtkapazität 19′ (Kapazität 19 der Figur 3).

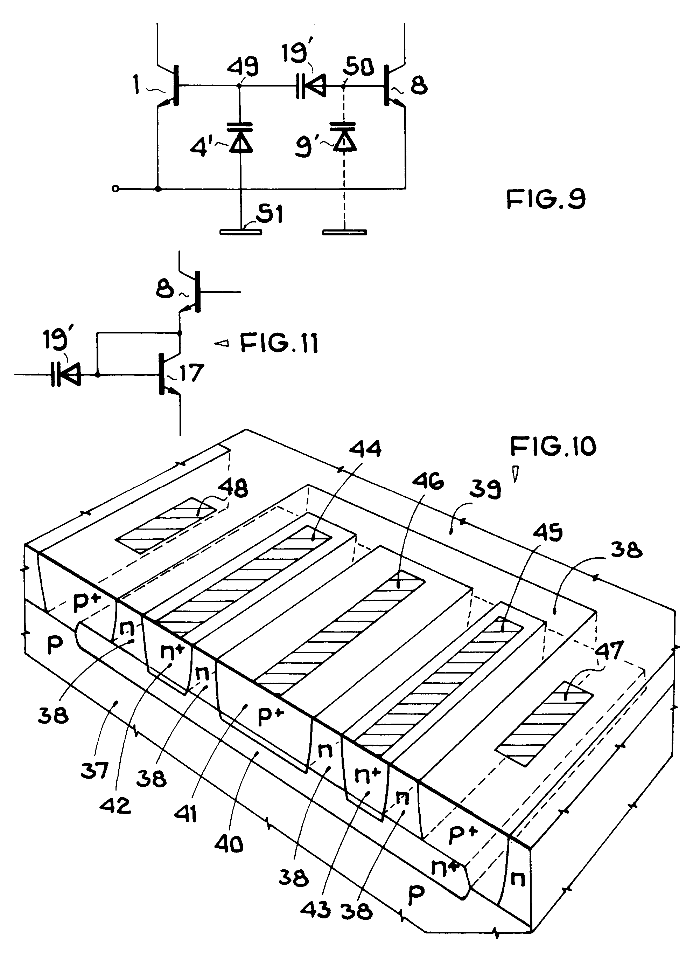

Die Figur 10 zeigt die Integration der in der Figur 9 vorhandenen Sperrschichtkapazitäten 4′ und 19′ (Sperrschichtkapazität 9′ ist dabei nicht berücksichtigt). Der Halbleiterkörper der Figur 10 besteht aus einem Substrat 37 und einer epitaktischen Schicht 38. Die Sperrschichtkapazität 4′ wird im wesentlichen durch die Bereiche 39 und die buried layer 40 gebildet. Die Sperrschichtkapazität 19′ wird durch den Bereich 41 und die buried layer 40 gebildet. Der Halbleiterbereich 39 wirkt gleichzeitig als Separationszone. Die Halbleiterzonen 42 und 43 sind Anschlußzonen für die buried layer 40. Die Anschlußzone 42 ist mittels der Elektrode 44 und die Anschlußzone 43 ist mittels der Elektrode 45 kontaktiert. Die Halbleiterzone 41 wird mittels der Elektrode 46 kontaktiert. Die Halbleiterzone 39 wird mittels der Elektroden 47 und 48 kontaktiert.

Die Elektroden 44 und 45 der Figur 10 sind mit dem Knoten 49 der Figur 9 verbunden. Die Elektrode 46 der Figur 10 ist mit dem Knoten 50 der Figur 9 verbunden. Die Elektroden 47 und 48 der Figur 10 stellen den Substratanschluß dar und sind mit dem Bezugspunkt 51 der Figur 9 verbunden.

Die Herstellung der Anordnung der Figur 10 erfolgt dadurch, daß ein Halbleiterkörper 1 vom ersten Leitungstyp mit der buried layer 40 vom zweiten Leitungstyp versehen wird. Dann wird die epitaktische Schicht 38 aufgebracht. Schließlich werden noch die Halbleiterzone 39 vom ersten Leitungstyp sowie die Halbleiterzone 41 vom ersten Leitungstyp und danach die Halbleiterzonen 42 und 43 vom zweiten Leitungstyp eingebracht.

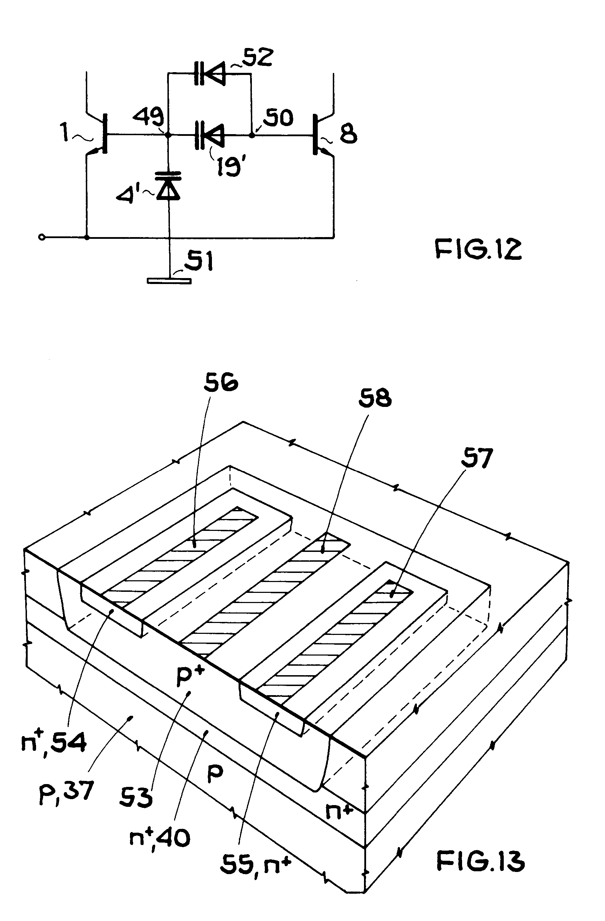

Die Figur 11 zeigt die Transistoren 8 und 17 der Figur 3 sowie die Realisierung des Kondensators 19 der Figur 3 durch eine Sperrschichtkapazität 19′.

Die Anordnung der Figur 12 unterscheidet sich von der Anordnung der Figur 10 dadurch, daß noch eine zusätzliche Sperrschichtkapazität 52 vorgesehen ist, die parallel zur Sperrschichtkapazität 19′ angeordnet ist.

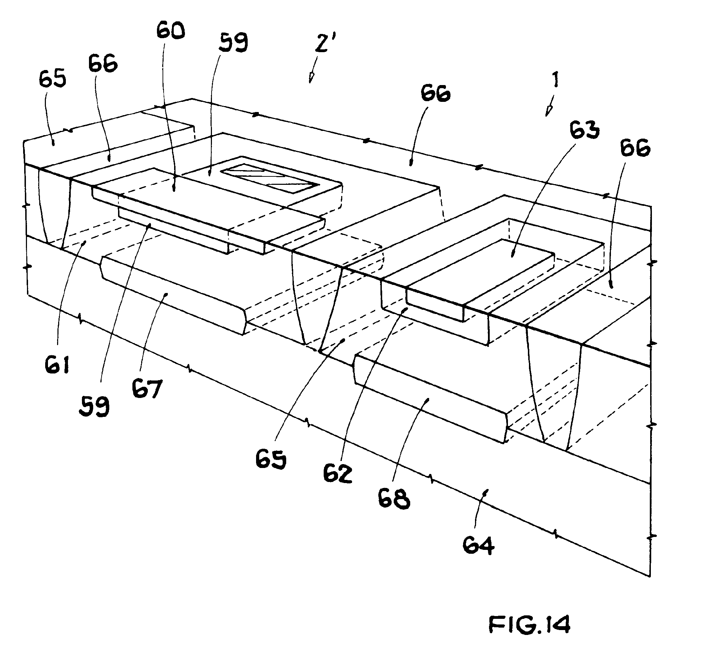

Die Figur 13 zeigt die Integration der beiden Sperrschichtkapazitäten 19′ und 52. Die Sperrschichtkapazität 19′ wird bei der Anordnung der Figur 12 durch die Halbleiterzone 53 und durch die buried layer 40 gebildet. Die Halbleiterzone 53 entspricht der Halbleiterterzone 41 in Figur 10. Die Sperrschichtkapazität 52 wird durch die Halbleiterzonen 54 und 55 vom gleichen Leitungstyp sowie durch die Halbleiterzone 53 gebildet. Die Halbleiterzone 54 wird durch die Elektrode 56 und die Halbleiterzone 55 wird durch die Elektrode 57 kontaktiert. Die Halbleiterzone 53 wird durch die Elektrode 58 kontaktiert.

Die Elektroden 56 und 57 der Figur 13 sind mit dem Knoten 49 der Figur 12 verbunden. Die Elektrode 58 der Figur 13 ist mit dem Knoten 50 der Figur 12 verbunden. Die Anwendung der Parallelschaltung von Kondensatoren (19′ und 52) und deren Realisierung nach der Figur 13 hat den Vorteil, daß für eine vorgegebene Gesamtkapazität zwischen den Knoten 49 und 50 (Figuren 9, 11 und 12) eine kleinere Kristallfläche ermöglicht wird.

Ein Pinchwiderstand 2′ besteht gemäß der Figur 14 aus einer Widerstandszone 59, die von zwei Halbleiterzonen 60 und 61 in vertikaler Richtung begrenzt wird. Die Halbleiterzonen 60 und 61 haben den entgegengesetzten Leitungstyp wie die Widerstandszone 59. Die Widerstandszone 59 wird im gleichen Verfahrensschritt wie die Basiszone 62 des in der Figur 14 neben dem Pinchwiderstand 2′ befindlichen npn Transistors 1 hergestellt, so daß die Widerstandszone 50 den gleichen Leitungstyp, die gleiche Leitfähigkeit und die gleiche Eindringtiefe wie die Basiszone 62 des Transistors 1 aufweist. In analoger Weise wird die über der Widerstandszone 59 liegende Halbleiterzone 60, die an die Halbleiteroberfläche grenzt, im gleichen Arbeitsgang wie die Emitterzone 63 des Transistors 1 hergestellt, so daß die Halbleiterzone 60 den gleichen Leitungstyp, die gleiche Leitfähigkeit sowie die gleiche Tiefe wie die Emitterzone 63 des Transistors 1 aufweist. Der Halbleiterkörper der integrierten Schaltungsanordnung besteht aus einem Substrat 64 vom ersten Leitungstyp und einer epitaktischen Schicht 65 vom zweiten Leitungstyp. Die elektrische Trennung der Bauelemente der Schaltungsanordnung der Figur 5 erfolgt durch Separationszonen 66, die den ersten Leitungstyp aufweisen. Die Widerstandszone 59 und die Basiszone 63 haben den ersten Leitungstyp. Unter dem Pinchwiderstand 2′ und unter dem Transistor 1 befinden sich vergrabene Schichten 67 und 68 vom zweiten Leitungstyp. Anstelle der Separationszonen 65 können auch sogenannte Oxidisolationszonen angewandt werden.

## Patentansprüche

1. Steuerbare Verstärkerschaltung mit einem Verstärkertransistor (1) und einem weiteren Transistor (8), der im Regelfall dem Verstärkertransistor (1) zumindest einen Teil des Eingangssignals entzieht, wobei der Verstärkertransistor (1) in Basisgrundschaltung geschaltet ist, und die Emitter der beiden Transistoren (1, 8) mit dem Eingang (3) der Schaltung verbunden sind, wobei eine Steuerschaltung (10) vorgesehen ist, die den Basisstrom (15) des weiteren Transistors (8) liefert, dadurch gekennzeichnet, daß die Steuerschaltung (10) auch den Basisstrom (14) des Verstärkertransistors (1) liefert und aus steuerbaren Stromquellen (11, 12; 25, 26; 33, 34; 33, 36) besteht, die durch ein einziges Steuersignal (13) angesteuert werden und die die Basiselektroden der beiden Transistoren (1, 8) derart gegensinnig ansteuert, daß die Summe der beiden Basisströme (14, 15) konstant bleibt.

2. Verstärkerschaltung nach Anspruch 1, dadurch gekennzeichnet, daß der Kollektor des weiteren Transistors (8) mit einer Spannungsquelle (7) verbunden ist.

3. Verstärkerschaltung nach Anspruch 1 oder 2, dadurch gekennzeichnet, daß am Kollektorausgang des Verstärkertransistors (1) ein Selektionskreis (6) vorgesehen ist.

4. Verstärkerschaltung nach einem der Ansprüche 1 bis 3, dadurch gekennzeichnet, daß ein dritter, als Diode geschalteter Transistor (17) vorgesehen ist, der mit seiner Emitterkollektorstrecke zwischen den Eingang der Schaltung (3) und den Emitter des weiteren Transistors (8) geschaltet ist.

5. Verstärkerschaltung nach Anspruch 4, dadurch gekennzeichnet, daß die Basis und der Kollektor des dritten Transistors (17) über einen Kondensator (18) mit dem Bezugspunkt verbunden sind.

6. Verstärkerschaltung nach Anspruch 4, dadurch gekennzeichnet, daß ein Kondensator (4) zwischen die Basis des ersten Transistors (1) und den Bezugspunkt geschaltet ist, und daß zwischen diesen Kondensator (4) und den gemeinsamen Basiskollektoranschluß des dritten Transistors (17) ein Kondensator (18) geschaltet ist.

7. Verstärkerschaltung nach einem der Ansprüche 1 bis 6, dadurch gekennzeichnet, daß die Steuerschaltung (10), die die Basisströme (14, 15) für den Verstärkertransistor (1) und den weiteren Transistor (8) liefert, eine Differenzschaltung (20, 21) mit zwei Transistoren sowie Stromspiegelschaltungen (25, 26) aufweist.

8. Verstärkerschaltung nach Anspruch 7, dadurch gekennzeichnet, daß die Emitter der Transistoren der Differenzschaltung (20, 21) miteinander verbunden sind und daß ein Pinchwiderstand (24) zwischen den Verbindungspunkt (23) der Emitter und den Bezugspunkt geschaltet ist.

9. Verstärkerschaltung nach Anspruch 7 oder 8, dadurch gekennzeichnet, daß ein Transistor (29) vorgesehen ist, dessen Kollektor mit dem Kollektor des einen Transistors (20) der Differenzschaltung verbunden ist und dessen Emitter mit dem Verbindungspunkt (23) der Emitter der beiden Transistoren (20, 21) der Differenzschaltung verbunden ist.

10. Verstärkerschaltung nach Anspruch 8, dadurch gekennzeichnet, daß ein Transistor (29′) vorgesehen ist, dessen Kollektor mit dem Kollektor des einen Transistors (20) der Differenzschaltung verbunden ist und dessen Emitter über einen weiteren Pinchwiderstand (30) mit dem Bezugspunkt verbunden ist.

11. Verstärkerschaltung nach einem der Ansprüche 1 bis 6, dadurch gekennzeichnet, daß die Steuerschaltung (10), die die Basisströme für den Verstärkertransistor (1) und den weiteren Transistor (8) liefert, eine Differenzschaltung mit zwei Transistoren (33, 34) sowie eine Stromspiegelschaltung aufweist, die die Differenzschaltung mit den beiden Transistoren (33, 34) ansteuert, und daß die Stromspiegelschaltung aus zwei Transistoren (31, 32) besteht, von denen der eine ein Mehrkollektortransistor (32) ist.

12. Verstärkerschaltung nach Anspruch 11, dadurch gekennzeichnet, daß der eine Kollektor (32b) des Mehrkollektortransistors der Stromspiegelschaltung der Verbindungspunkt (25) der Emitter der beiden Transistoren der Differenzschaltung ansteuert.

13. Verstärkerschaltung nach Anspruch 11 oder 12, dadurch gekennzeichnet, daß der Emitter des den Mehrkollektortransistor ansteuernden Transistors (31) des Stromspiegels mit einem Kollektor (32a) des Mehrkollektortransistors sowie über einen Pinchwiderstand (24′) mit dem Bezugspunkt verbunden ist.

14. Verstärkerschaltung nach einem der Ansprüche 11 bis 13, dadurch gekennzeichnet, daß der Emitter des Mehrkollektortransistors (32) des Stromspiegels mit dem Betriebspotential (27) verbunden ist.

15. Verstärkerschaltung nach einem der Ansprüche 11 bis 14, dadurch gekennzeichnet, daß die Basis des den Mehrkollektortransistors ansteuernden Stromspiegeltransistors (31) mit einer Spannungsquelle (22) verbunden ist.

16. Verstärkerschaltung nach einem der Ansprüche 11 bis 15, dadurch gekennzeichnet, daß der eine der beiden Transistoren der Differenzschaltung ein Mehrkollektortransistor (36) ist und daß der eine Kollektor (36b) dieses Mehrkollektortransistors den einen Ausgang der Differenzschaltung bildet, während ein anderer Kollektor (36a) des Mehrkollektortransistors mit dem Kollektor des anderen Transistors (33) der Differenzschaltung verbunden ist.

17. Verstärkerschaltung nach einem der Ansprüche 6 bis 16, dadurch gekennzeichnet, daß die Schaltung eine integrierte Schaltung ist, daß der Halbleiterkörper aus einem Substrat (37) vom ersten Leitungstyp und einer epitaktischen Schicht (38) vom zweiten Leitungstyp besteht, daß im Substrat eine Buried Layer (40) vom zweiten Leitungstyp vorgesehen ist, daß in der epitaktischen Schicht (38) eine Halbleiterzone (39) vom ersten Leitungstyp vorgesehen ist, die mit der Buried Layer (40) eine Sperrschichtkapazität bildet, welche als Abblockkapazität (4′) eines Transistors wirkt, und daß in der epitaktischen Schicht eine zweite Halbleiterzone (41) vom ersten Leitungstyp vorgesehen ist, die mit der Buried Layer eine Sperrschichtkapazität (19) bildet, die als Kondensator wirkt, der zwischen der Abblockkapazität (4′) und einer nachfolgenden, als Diode geschalteten Transistor (17) geschaltet ist.

18. Verstärkerschaltung nach Anspruch 17, dadurch gekennzeichnet, daß in der zweiten Halbleiterzone (53) vom ersten Leitungstyp zwei Halbleiterzonen (54, 55) vom zweiten Leitungstyp vorgesehen sind, die mit der zweiten Halbleiterzone (53) vom ersten Leitungstyp Sperrschichtkapazitäten bilden, die parallel zu derjenigen Sperrschichtkapazität geschaltet sind, die durch die zweite Halbleiterzone (53) und die Buried Layer (40) gebildet wird.

## Claims

1. A controllable amplifier circuit with an amplifier transistor (1) and a further transistor (8) which normally withdraws at least a part of the input signal from the amplifier transistor (1), wherein the amplifier transistor (1) is connected as a grounded base circuit and the emitters of the two transistors (1, 8) are connected to the input (3) of the circuit, wherein a control circuit (10) is provided which supplies the base current (15) of the further transistor (8), characterised in that the control circuit (10) also supplies the base current (14) of the amplifier transistor (1) and consists of controllable current sources (11, 12; 25, 26; 33, 34; 33, 36) which are driven by a single control signal (13) and which drive the base electrodes of the two transistors (1, 8) in opposing fashion such that the sum of the two base currents (14, 15) remains constant.

2. An amplifier circuit as claimed in Claim 1, characterised in that the collector of the further transistor (8) is connected to a voltage source (7).

3. An amplifier circuit as claimed in Claim 1 or 2, characterised in that a selection circuit (6) is provided at the collector output of the amplifier transistor (1).

4. An amplifier circuit as claimed in one of Claims 1 to 3, characterised in that a third transistor (17) is provided which is connected as diode and the emitter-collector path of which is connected between the input of the circuit (3) and the emitter of the further transistor (8).

5. An amplifier circuit as claimed in Claim 4, characterised in that the base and the collector of the third transistor (17) are connected via a capacitor (18) to the reference point.

6. An amplifier circuit as claimed in Claim 4, characterised in that a capacitor (4) is connected between the base of the first transistor (1) and the reference point, and that a capacitor (18) is connected between this capacitor (4) and the common base-collector terminal of the third transistor (17).

7. An amplifier circuit as claimed in one of Claims 1 to 6, characterised in that the control circuit (10), which supplies the base currents (14, 15) for the amplifier transistor (1) and the further transistor (8), comprises a differential circuit (20, 21) with two transistors and current mirror circuits (25, 26).

8. An amplifier circuit as claimed in Claim 7, characterised in that the emitters of the transistors of the differential circuit (20, 21) are connected to one another and that a pinch resistor (24) is connected between the connection point (23) of the emitters and the reference point.

9. An amplifier circuit as claimed in Claim 7 or 8, characterised in that a transistor (29) is provided, the collector of which is connected to the collector of the first transistor (20) of the differential circuit, and the emitter of which is connected to the connection point (23) of the emitters of the two transistors (20, 21) of the differential circuit.

10. An amplifier circuit as claimed in Claim 8, characterised in that a transistor (29′) is provided, the collector of which is connected to the collector of the first transistor (20) of the differential circuit and the emitter of which is connected via a further pinch resistor (30) to the reference point.

11. An amplifier circuit as claimed in one of Claims 1 to 6, characterised in that the control circuit (10), which supplies the base currents for the amplifier transistor (1) and the further transistor (8), comprises a differential circuit with two transistors (33, 34) and a current mirror circuit which drives the differential circuit with the two transistors (33, 34), and that the current mirror circuit consists of two transistors (31, 32), of which one is a multi-collector transistor (32).

12. An amplifier circuit as claimed in Claim 11, characterised in that the first collector (32b) of the multi-collector transistor of the current mirror circuit drives the connection point (25) of the emitters of the two transistors of the differential circuit.

13. An amplifier circuit as claimed in Claim 11 or 12, characterised in that the emitter of that transistor (31) of the current mirror which drives the multi-collector transistor is connected to a collector (32a) of the multi-collector transistor and via a pinch resistor (24′) to the reference point.

14. An amplifier circuit as claimed in one of Claims 11 to 13, characterised in that the emitter of the multi-collector transistor (32) of the current mirror is connected to the operating potential (27).

15. An amplifier circuit as claimed in one of Claims 11 to 14, characterised in that the base of the current mirror transistor (31) which drives the multi-collector transistor is connected to a voltage source (22).

16. An amplifier circuit as claimed in one of Claims 1 to 15, characterised in that one of the two transistors of the differential circuit is a multi-collector transistor (36), and that one collector (36b) of this multi-collector transistor forms one output of the differential circuit while another collector (36a) of the multi-collector transistor is connected to the collector of the other transistor (33) of the differential circuit.

17. An amplifier circuit as claimed in one of Claims 6 to 16, characterised in that the circuit is an integrated circuit and that the semiconductor body consists of a substrate (37) of the first conductivity type and an epitaxial layer (38) of the second conductivity type, that a buried layer (40) of the second conductivity type is provided in the substrate, that a semiconductor zone (39) of the first conductivity type is provided in the epitaxial layer (38), which semiconductor zone (39), together with the buried layer (40), forms a depletion layer capacitance which acts as blocking capacitance (4′) of a transistor, and that a second semiconductor zone (41) of the first conductivity type is provided in the epitaxial layer, which second semiconductor zone (41), together with the buried layer, forms a depletion layer capacitance (19) which acts as capacitor connected between the blocking capacitance (4′) and a following transistor (17) connected as diode.

18. An amplifier circuit as claimed in Claim 17, characterised in that two semiconductor zones (54, 55) of the second conductivity type are provided in the second semiconductor zone (53) of the first conductivity type, which two semiconductor zones (54, 55), together with the second semiconductor zone (53) of the first conductivity type, form depletion layer capacitances which are connected in parallel to the depletion layer capacitance formed by the second semiconductor zone (53) and the buried layer (40).

## Revendications

1. Circuit amplificateur commandable, comprenant un transistor amplificateur (1) et un second transistor (8) qui prélève normalement une partie du signal d'entrée depuis le transistor amplificateur (1), le transistor amplificateur (1) étant monté en circuit à base commune, et les émetteurs des deux transistors (1, 8) étant reliés à l'entrée (3) du circuit, un circuit de commande (10) étant prévu, qui fournit le courant de base (15) du second transistor (8), caractérisé en ce que le circuit de commande (10) fournit également le courant de base (14) du transistor amplificateur (1), et est constitué par des sources de courant commandables (11, 12 ; 25, 26; 33, 34 ; 33, 36) qui sont pilotées par un signal de commande unique (13), et qui pilote les électrodes de base des deux transistors (1, 8) de telle manière que la somme des deux courants de base (14, 15) reste constante.

2. Circuit amplificateur selon la revendication 1, caractérisé en ce que le collecteur du second transistor (8) est relié à une source de tension (7).

3. Circuit amplificateur selon l'une ou l'autre des revendications 1 et 2, caractérisé en ce qu'il est prévu un circuit de sélection (6) à la sortie du collecteur du transistor amplificateur (1).

4. Circuit amplificateur selon l'une des revendications 1 à 3, caractérisé en ce qu'il est prévu un troisième transistor (17), branché en tant que diode, qui est branché par son trajet émetteur/collecteur entre l'entrée du circuit (3) et l'émetteur du second transistor (8).

5. Circuit amplificateur selon la revendication 4, caractérisé en ce que la base et le collecteur du troisième transistor (17) sont reliés au point de référence via un condensateur (18).

6. Circuit amplificateur selon la revendication 4, caractérisé en ce qu'un condensateur (4) est branché entre la base du premier transistor et le point de référence, et en ce qu'un condensateur (18) est branché entre ce condensateur (4) et le raccordement commun de la base et du collecteur du troisième transistor (17).

7. Circuit amplificateur selon l'une quelconque des revendications 1 à 6, caractérisé en ce que le circuit de commande (10), qui délivre les courants de base (14, 15) pour le transistor amplificateur (1) et pour le second transistor (8) comprend un circuit différentiel (20, 21) avec deux transistors ainsi que des circuits à courants symétriques (25, 26).

8. Circuit amplificateur selon la revendication 7, caractérisé en ce que les émetteurs des transistors du circuit différentiel (20, 21) sont reliés l'un à l'autre, et en ce qu'une résistance à base pincée (24) est branchée entre le point de jonction (23) des émetteurs et le point de référence.

9. Circuit amplificateur selon l'une ou l'autre des revendications 7 et 8, caractérisé en ce qu'il est prévu un transistor (29) dont le collecteur est relié au collecteur de l'un des transistors (20) du circuit différentiel, et dont l'émetteur est relié au point de jonction (23) des émetteurs des deux transistors (20, 21) du circuit différentiel.

10. Circuit amplificateur selon la revendication 8, caractérisé en ce qu'il est prévu un transistor (29′) dont le collecteur est relié au collecteur de l'un des transistors (20) du circuit différentiel, et dont l'émetteur est relié au point de référence via une autre résistance à base pincée (30).

11. Circuit amplificateur selon l'une quelconque des revendications 1 à 6, caractérisé en ce que le circuit de commande (10), qui délivre les courants de base pour le transistor amplificateur (1) et pour le second transistor (8), comprend un circuit différentiel avec deux transistors (33, 34) ainsi qu'un circuit à courants symétriques, qui pilote le circuit différentiel avec les deux transistors (33, 34), et en ce que le circuit symétrique est constitué de deux transistors (31, 32) dont l'un est un transistor (32) à multiples collecteurs.

12. Circuit amplificateur selon la revendication 11, caractérisé en ce que l'un des collecteurs (32b) du transistor à multiples collecteurs du circuit symétrique pilote le point de jonction (35) des émetteurs des deux transistors du circuit différentiel.

13. Circuit amplificateur selon l'une ou l'autre des revendications 11 et 12, caractérisé en ce que l'émetteur du transistor (31) du circuit symétrique, qui pilote le transistor à multiples collecteurs, est relié à un collecteur (32a) du transistor à multiples collecteurs, ainsi qu'au point de référence via une résistance à base pincée (24).

14. Circuit amplificateur selon l'une quelconque des revendications 11 à 13, caractérisé en ce que l'émetteur du transistor à multiples collecteurs (32) du circuit symétrique est relié au potentiel de service (27).

15. Circuit amplificateur selon l'une quelconque des revendications 11 à 14, caractérisé en ce que la base du transistor symétrique (31) qui pilote le transistor à multiples collecteurs, est reliée à une source de tension (22).

16. Circuit amplificateur selon l'une quelconque des revendications 11 à 15, caractérisé en ce que l'un des deux transistors du circuit différentiel est un transistor (36) à multiples collecteurs, et en ce que l'un des collecteurs (36b) de ce transistor à multiples collecteurs forme l'une des sorties du circuit différentiel, tandis qu'un autre collecteur (36a) du transistor à multiples collecteur est relié au collecteur de l'autre transistor (33) du circuit différentiel.

17. Circuit amplificateur selon l'une quelconque des revendications 6 à 16, caractérisé en ce que le circuit est un circuit intégré, en ce que le corps semi-conducteur est formé d'un substrat (37) du premier type de conduction et d'une couche épitaxiale (38) du second type de conduction, en ce qu'il est prévu dans le substrat une couche enterrée (40) du second type de conduction, en ce qu'il est prévu dans la couche épitaxiale (38) une couche semi-conductrice (39) du premier type de conduction qui forme avec la couche enterrée (40) une capacité à couche diélectrique, laquelle agit en tant que capacité de blocage (4′) d'un transistor, et en ce qu'il est prévu dans la couche épitaxiale une seconde zone semi-conductrice (41) du premier type de conduction, qui forme avec la couche enterrée une capacité à couche diélectrique (19′), laquelle agit en tant que condensateur et est branchée entre la capacité de blocage (4′) et un transistor suivant (17) branché en tant que diode.

18. Circuit amplificateur selon la revendication (17), caractérisé en ce qu'il est prévu dans la seconde zone semi-conductrice (53) du premier type de conduction deux zones semi-conductrices (54, 55) du second type de conduction, qui forment avec la seconde zone semi-conductrice (53) du premier type de conduction des capacités à couches diélectriques, qui sont branchées parallèlement à cette capacité à couche diélectrique qui est formée par la seconde zone semi-conductrice (53) et par la couche enterrée (40).
